Europäisches Patentamt

European Patent Office

Office européen des brevets

(19)

(11) Veröffentlichungsnummer: **0 186 177**

**A2**

(12) **EUROPÄISCHE PATENTANMELDUNG**

(21) Anmeldenummer: 85116475.6

(22) Anmeldetag: 23.12.85

(51) Int. Cl.⁴: **B 23 K 20/02**
**B 23 K 20/10**

(30) Priorität: 28.12.84 DE 3447657

(43) Veröffentlichungstag der Anmeldung:
02.07.86 Patentblatt 86/27

(84) Benannte Vertragsstaaten:
AT BE CH DE FR GB IT LI LU NL SE

(71) Anmelder: Foton Production Automation GmbH
Präzisionsmaschinenbau
Notburgastrasse 5
D-8000 München 19(DE)

(72) Erfinder: Jutrzenka, Franz, Dr.
Dompfaffstrasse 12
D-8031 Eichenau(DE)

(74) Vertreter: Patentanwälte Grünecker, Kinkeldey,
Stockmair & Partner
Maximilianstrasse 58
D-8000 München 22(DE)

(54) Drahtklemmvorrichtung.

(57) Es wird eine Drahtklemmvorrichtung für eine Maschine zum Befestigen von Verbindungsdrähten an den Anschlußstellen eines Halbleiterbauelements und des das Halbleiterbauelement aufnehmenden Gehäuses angegeben. Die Vorrichtung weist eine bewegliche Klemmbacke auf, die von einer Feder gegen eine feste Klemmbacke gedrückt wird und unter der Wirkung eines elektrischen Antriebes von dieser gelöst werden kann. Der elektrische Antrieb enthält wenigstens ein Piezoelement. Die Vorrichtung erlaubt eine Steigerung der Ansprechgeschwindigkeit.

FIG.1

<u>Drahtklemmvorrichtung</u>

<u>B e s c h r e i b u n g</u>

Die Erfindung bezieht sich auf eine Drahtklemmvorrichtung
für eine Maschine zum Befestigen von Verbindungsdrähten,
insbesondere Goldfäden, an den Anschlußstellen eines Halbleiterbauelements und des das Halbleiterbauelement aufnehmenden Gehäuses, mit einer feststehenden und einer dieser gegenüberstehenden, beweglich gelagerten Klemmbacke
und einem elektrischen Antrieb zum Bewegen der beweglichen
Klemmbacke gegen die Kraft einer Rückstellfeder. Eine solche Drahtklemmvorrichtung ist aus der US-PS 37 76 447 bekannt.

Die genannte Druckschrift zeigt sehr anschaulich eine Maschine der genannten Art und deren Arbeitsweise, und es
soll zur Veranschaulichung der Probleme, mit denen sich
die vorliegende Erfindung beschäftigt, hierauf kurz Bezug
genommen werden.

Die Halbleiterbauelemente, die mit einer Maschine der genannten Art behandelt werden, sind zumeist sogenannte
Chips, die hochintegrierte Halbleiterschaltkreise tragen
und eine Vielzahl von Anschlußflecken aufweisen, die mit
den Anschlußstellen eines den Chip aufnehmenden Gehäuses
zu verbinden sind. Wegen der geringen Abmessungen kommen
hierfür nur dünnste Drähte, besser gesagt Fäden in Betracht.
In der Praxis verwendet man hierfür Goldfäden mit Durchmessern in der Größenordnung von 25 μ und weniger. Dieser
Goldfaden verläßt die genannte Maschine durch ein Kapillare
genanntes Bauteil, das zugleich die Aufgabe hat, den Faden
auf die Anschlußflecken zu drücken und dadurch an diesen
zu befestigen. Hierzu wird zunächst ein aus der Kapillare
herausschauendes Endstück des Goldfadens mittels eines
Funkens zu einem Kügelchen verschmolzen, das anschließend
von den Rändern der Kapillare auf einen ersten Anschlußfleck gedrückt wird. Es erfolgt dort eine Verschweißung des Kügelchens mit dem Anschlußfleck. Anschließend wird die Kapillare zum nächsten Anschlußfleck bewegt, wobei sich Goldfaden aus der Kapillare herauszieht. Die Kapillare wird dann auf den zweiten Anschlußfleck niederbewegt, wo ihr Rand den auf ihr liegenden Goldfaden auf den zweiten Anschlußfleck drückt und mit diesem verschweißt. Anschließend hebt die Kapillare an und es wird nun der Goldfaden innerhalb der Maschine, d. h. oberhalb von der Kapillare festgeklemmt. Wenn dann die Kapillare weiter abgehoben wird, dann reißt der Goldfaden an der Schweißstelle am zweiten Anschlußfleck, die eine Sollbruchstelle definiert, ab. Das aus der Kapillare heraushängende Ende des Goldfadens kann nun wieder mit einem Funken zu einem Kügelchen verschmolzen werden.

Da die zu bearbeitenden Halbleiterbauelemente sehr kleine Abmessungen haben, sind die Bewegungswege, die von der Kapillare auszuführen sind, sehr gering, und es ist daher möglich, die Kapillare programmgesteuert sehr schnell vom einen zum nächsten Anschlußfleck zu bewegen. Die Bewegung der Klemmbacke erfolgt bei dem bekannten Gerät mittels eines Elektromagneten, der die Klemmbacke gegen die Kraft einer Rückstellfeder von der feststehenden Klemmbacke abhebt. Es hat sich herausgestellt, daß die Arbeitsgeschwindigkeit der Maschine durch die ungenügende Ansprechgeschwindigkeit des Elektromagneten begrenzt ist. Die gegenwärtig verwendeten Elektromagneten in Maschinen der genannten Art zeigen Ansprechzeiten in der Größenordnung von etwa 10 msec. Gewünscht werden jedoch Ansprechzeiten in der Größenordnung von 1 msec und darunter. Man könnte zur Steigerung der Ansprechgeschwindigkeit des Elektromagneten diesen mit höherer Anzugsspannung betreiben, doch sind die dann entstehenden magnetischen und elektrischen Störfelder aus anderen Gründen nachteilig für den gesamten Arbeitsablauf.

Der Erfindung liegt daher die Aufgabe zugrunde, eine Klemmvorrichtung der oben genannten Art anzugeben, die eine erhöhte Ansprechgeschwindigkeit aufweist.

Diese Aufgabe wird durch die kennzeichnenden Merkmale des Patentanspruchs 1 gelöst. Vorteilhafte Ausgestaltungen der Erfindung sind Gegenstand der Unteransprüche.

Die Erfindung löst sich somit vom elektromagnetischen Antrieb und geht auf einen piezoelektrischen Antrieb über. Aufgrund des geringen Durchmessers des Goldfadens und der kleinen aufzubringenden Kräfte ist der Einsatz eines Piezoelements als Kraftquelle möglich. Die auszuführenden Wege liegen in der Größenordnung von nur etwa 1 mm, solche Wege lassen sich erzielen, wenn man beispielsweise einen piezoelektrischen Längsschwinger von etwa 30 mm Länge und 0,5 mm Dicke auf einen flexiblen Metallstreifen von 0,5 mm Dicke aufklebt, so daß ein Bauelement entsteht, das sich nach Art eines Bimetallstreifens durchbiegt, wenn an das Piezoelement eine elektrische Spannung angelegt wird. Eine Erregerspannung von etwa 600 Volt ergibt eine Durchbiegung von etwa 1 bis 1,5 mm, je nach Steifigkeit des Metallstreifens.

Das Piezoelement läßt sich ähnlich dem früher verwendeten Elektromagneten programmgesteuert erregen, wobei freilich darauf geachtet werden muß, daß die Erregerspannung in der das Piezoelement zusammenziehenden Richtung 1/3 der Spannung in der das Piezoelement ausdehnenden Richtung nicht übersteigt, um das Element nicht zu zerstören. Durch schaltungstechnische Maßnahmen ist dieses unschwierig zu erreichen.

Der Einsatz des Piezoelementes als Antrieb überwindet die Beschränkungen hinsichtlich der Arbeitsgeschwindigkeit, die die Elektromagneten auferlegt haben; darüber hinaus werden magnetische Störfelder vermieden, auf die Halbleiterbauelemente unter Umständen empfindlich sind, und schließlich wird auch die Ansteuerschaltung vereinfacht, da sich die zu beherrschenden Leistungen verringern lassen.

Die Erfindung soll nachfolgend unter Bezugnahme auf in den Zeichnungen dargestellte Ausführungsformen näher erläutert werden. Es zeigt:

Fig. 1 eine Drahtklemmvorrichtung nach der vorliegenden Erfindung mit einem Piezoelement als Antrieb für die bewegliche Klemmbacke;

Fig. 2 als Ausschnitt eine Doppelanordnung mit zwei Piezoelementen als Antrieb;

Fig. 3 eine Ansteuerschaltung für den piezoelektrischen Antrieb nach Fig. 1.

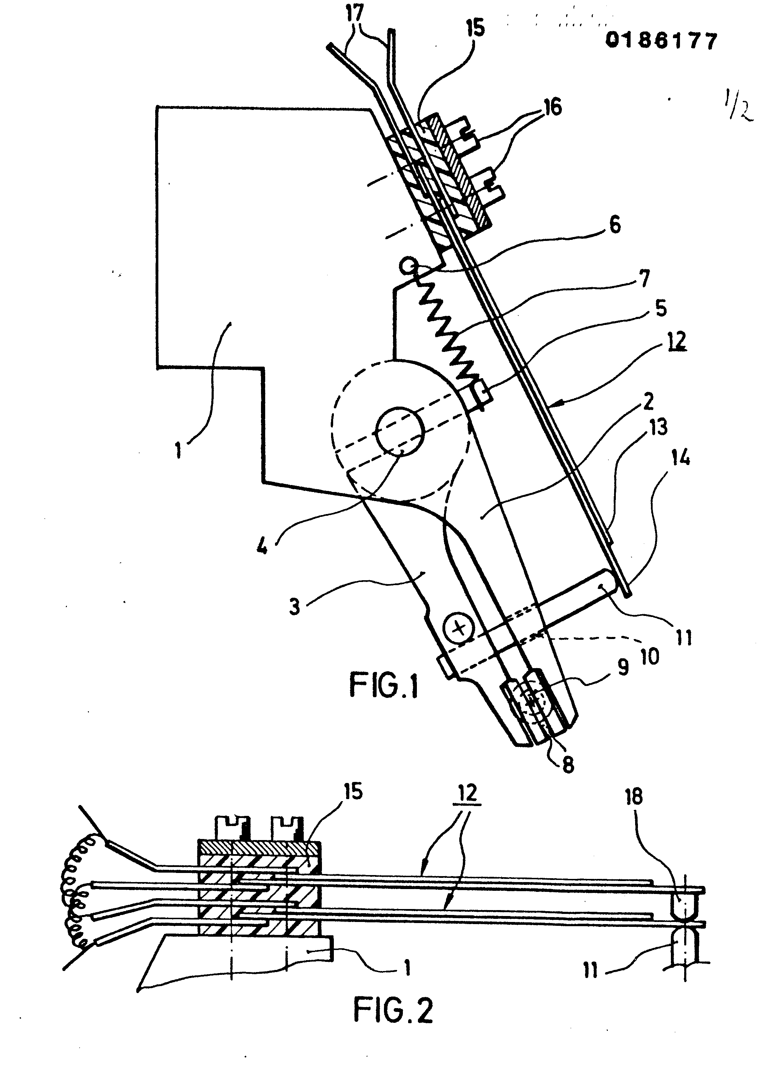

In Fig. 1 erkennt man eine Drahtklemmvorrichtung, bestehend aus einem Halter 1, an dem eine feststehende Klemmbacke 2 ausgebildet ist, der eine an dem Halter 1 schwenkbar gelagerte bewegliche Klemmbacke 3 gegenübersteht. Der Halter 1 ist Teil einer Maschine zum Befestigen von Verbindungsdrähten an den Anschlußflecken eines Halbleiterbauelements und des dieses aufnehmenden Gehäuses und ist gegenüber einem das Halbleiterbauelement mit dem Gehäuse aufnehmenden Tisch beweglich, um alle Anschlußflecken erreichen zu können. Diese Einzelheiten sind hier nicht dargestellt, es kann zur näheren Erläuterung auf die US-PS 37 76 447 verwiesen werden.

Die bewegliche Schwenkbacke 3 ist um einen Drehzapfen 4 an dem Halter 1 schwenkbar gelagert. Sie ist von einem Stift 5 durchdrungen, der ihre Drehachse schneidet und mit ihr drehfest verbunden ist. Zwischen dem freien Ende des Stiftes 5 und einem Haltestift 6, der an dem Halter 1 angebracht ist, ist eine Zugfeder 7 eingespannt, die die bewegliche Klemmbacke 3 in die in Fig. 1 dargestellte Schließstellung drückt.

Die Klemmbacken 2 und 3 sind an ihren freien Enden mit Klemmflächen 8 versehen. Unterhalb derselben befindet sich das Einführende einer Kapillare 9, die in Fig. 1 gestrichelt eingezeichnet zu erkennen ist. Die feststehende Klemmbacke 2 weist eine Querbohrung 10 auf, die von einem Betätigungsstift 11 durchdrungen ist, der in der beweglichen Klemmbacke 3 verankert ist. Etwa parallel zu den Klemmbacken 2 und 3 erstreckt sich ein piezoelektrischer Antrieb, der insgesamt mit 12 bezeichnet ist. Dieser besteht im wesentlichen aus einem längsschwingenden piezoelektrischen Element 13 von streifenförmiger Gestalt, das ganzflächig mit einem flexiblen Metallstreifen 14 fest verbunden ist. Dieser Antrieb 12 ist einenends in einem Isolierkörper 15 befestigt, der seinerseits mittels Schrauben 16 oder dergleichen an dem Halter 1 befestigt ist. Das andere Ende des piezoelektrischen Antriebs 12, genauer gesagt die dem Piezoelement 13 abgewandte Seite des Metallstreifens 14 liegt auf dem Betätigungsstift 11 so auf, daß im Ruhezustand des Antriebes 12 die Klemmbacken 3 gegen die Kraft der Rückstellfeder 7 in ihre Öffnungsstellung gedrückt ist.

Innerhalb des Isolierkörpers 15 liegen elektrische Anschlußfahnen 17 an dem Metallstreifen 14 und an der diesem abgewandten Seite des piezoelektrischen Elements 13 an. Der Metallstreifen 14 ist mit der ihr zugewandten Seite des piezoelektrischen Elements 13 elektrisch leitend verbunden.

Wenn im Betrieb an die Anschlußfahnen 17 eine elektrische Gleichspannung passender Polarität angelegt wird, dann zieht sich das piezoelektrische Element 13 zusammen, seine Länge wird kleiner. Da das piezoelektrische Element fest mit dem Metallstreifen 14 verbunden ist, beispielsweise mit ihm verklebt ist, entwickelt sich an dem piezoelektrischen Antrieb 12 derselbe Effekt, den man von Bimetallstreifen her kennt, die aus piezoelektrischem Element und Metallstreifen 14 bestehende Anordnung verbiegt sich. Dabei läßt der Druck des freien Endes des Metallstreifens 14 auf den Betätigungsstift 11 nach und die bewegliche Klemmbacke 3 verschwenkt infolge der Kraft der Rückstellfeder 7, so daß sich die Klemmbacken 2 und 3 oberhalb der Kapillare 9 schließen. Wenn der Metallstreifen 14 vollständig von dem Betätigungsstift abhebt, ist die Schließkraft der Klemmbacken 2 und 3 allein von der Feder 7 bestimmt. Wird diese Spannung vom piezoelektrischen Element wieder entfernt, dann bringt das piezoelektrische Element 13 die Klemmbacken gegen die Kraft der Rückstellfeder 7 wieder in ihre Öffnungsstellung.

Fig. 2 zeigt eine Anordnung, bei der zur Kraftverstärkung zwei piezoelektrische Antriebe der in Fig. 1 dargestellten Art übereinander angeordnet sind. Die beiden Antriebe sind einenends in einen gemeinsamen Isolierkörper 15 eingespannt. Der obere der beiden Antriebe 12 trägt anderenends auf der Unterseite seines Metallstreifens 14 einen Stift 18, der

auf das Ende des Metallstreifens 14 des darunter liegenden piezoelektrischen Antriebs 12 drückt. Die beiden piezoelektrischen Elemente 12 sind somit mechanisch parallel geschaltet. Sie sind auch elektrisch parallel geschaltet, wie durch die links in Fig. 2 dargestellten Leitungsverbindungen angedeutet werden soll.

Es sei erwähnt, daß die Zeichnungen den Anmeldungsgegenstand in etwa dreifacher Vergrößerung zeigen. In der gezeigten Anordnung sind Durchbiegungen gegen die Kraft der Feder 7 von etwa 1 bis 1,5 mm mit zwei piezoelektrischen Antrieben der dargestellten Art erzielbar.

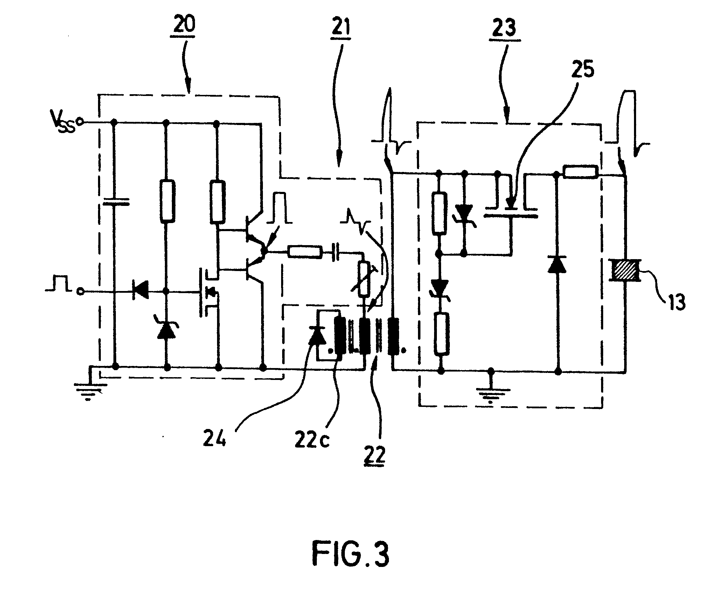

Eine Ansteuerschaltung für ein Piezoelement in einer erfindungsgemäßen Vorrichtung soll anschließend kurz unter Bezugnahme auf Fig. 3 erläutert werden.

Die Ansteuerschaltung besteht im wesentlichen aus einem Impulsverstärker 20, einem diesem nachgeschalteten Differenzierglied 21, einem Transformator 22 und einem Ansteuerkreis 23 für das Piezoelement 13. Mittels des Impulsverstärkers 20 werden einlaufende rechteckförmige Steuerimpulse verstärkt. Sie werden anschließend in einem Differenzierglied differenziert, so daß an den Impulsanstiegs- und Abstiegsflanken nadelförmige Impulse unterschiedlicher Polarität entstehen. Diese Impulse gelangen in einem Transformator, der die Spannung der Impulse hinauftransformiert. Der Transformator 22 weist weiterhin eine dritte Wicklung 22c auf, der eine Diode 24 parallel geschaltet ist. Die Polarität der Diode ist so gewählt, daß im dargestellten Ausführungsbeispiel die positiven Impulse von der Primärseite auf die Sekundärseite des Transformators ungedämpft übertragen werden, die negativen Impulse jedoch durch einen Kurzschluß der dritten Transformatorwicklung 22c gedämpft werden. Aus diesem Grunde haben die auf der Sekundärseite des Transformators erscheinenden transformierten Impulse unterschiedlicher Polarität sehr stark voneinander abweichende Amplituden.

Auf der Sekundärseite des Transformators 22 liegt in Reihe zum Piezoelement 13 ein HEXFET-Transistor 25, der durch eine in ihm enthaltene Diode die Eigenschaft aufweist, im gesperrten Zustand Stromimpulse in einer Richtung niederohmig durchzulassen, Spannung in der anderen Richtung aber hochohmig sperrt. Die auf der Sekundärseite des Transformators 22 erscheinenden positiven Impulse legen deshalb das Piezoelement 13 an Spannung. Da das Piezoelement 13 selbst auch hochohmig ist, wird diese Spannung gehalten, solange der HEXFET-Transistor gesperrt gehalten wird. Das Piezoelement 13 verharrt daher in dem ihm von der Spannung aufgezwungenen mechanischen Zustand, bis durch den Impuls umgekehrter Polarität und niedrigerer Amplitude der HEXFET-Transistor leitfähig gemacht wird und sich die an dem Piezoelement 13 anliegende Spannung abbauen kann.

Der Grund für die Dämpfung der Impulse negativer Polarität liegt darin, daß das Piezoelement von Impulsen zu großer Spannung der genannten Polarität zerstört werden könnte. Aus diesem Grunde ist zusätzlich zu dem Piezoelement 13 eine Diode parallel geschaltet, die die Spannung ungeeigneter Polarität kurzschließt.

Mit der dargestellten Anordnung erreicht man unschwierig Ansprechzeiten von 1 msec und darunter, so daß mit dieser die Arbeitsgeschwindigkeit der beschriebenen Maschine beachtlich gesteigert werden kann. Darüber hinaus sind die nachteiligen Einflüsse von Magnetfeldern vermieden. Als letzter Vorteil sei noch erwähnt, daß die Vorrichtung zur Geräuschverminderung beiträgt.

GRUNECKER. KINKELDEY. STOCKMAIR & PARTNER

A GRUNECKER
DR H KINKELDEY
DR W STOCKMAIR
DR F SCHUMANN
P H JAKOB
DR G BEZOLD
W MEISTER
H HILGERS
DR H MEYER-PLATH
DR M BOTT-BODENHAUSEN
DR U KINKELDEY

8000 MÜNCHEN 22
MAXIM. ANSTRASSE 58

PATENTANW **0186177**

Foton Production Automation
GmbH Präzisionsmaschinenbau
Notburgastraße 5
8000 München 19

EP 2748-50/to

# Drahtklemmvorrichtung

## Patentansprüche

1. Drahtklemmvorrichtung für eine Maschine zum Befestigen von Verbindungsdrähten, insbesondere Goldfäden, an den Anschlußstellen eines Halbleiterbauelements und des das Halbleiterbauelement aufnehmenden Gehäuses mit einer feststehenden und einer dieser gegenüberstehenden, beweglich gelagerten Klemmbacke und einem elektrischen Antrieb zum Bewegen der beweglichen Klemmbacke gegen die Kraft einer Rückstellfeder, dadurch g e k e n n z e i c h n e t , daß der Antrieb (12) wenigstens ein Piezoelement (13) enthält, das mechanisch auf die bewegliche Klemmbacke (3) einwirkt.

2. Klemmvorrichtung nach Anspruch 1, dadurch g e k e n n - z e i c h n e t , daß das Piezoelement (13) ein streifenförmiger Längsschwinger ist und auf einem flexiblen Metallstreifen (14) aufgeklebt ist, mit diesem einenends fest eingespannt ist und mit dem anderen Ende auf die bewegliche Klemmbacke (3) wirkt.

3. Klemmvorrichtung nach Anspruch 2, dadurch g e k e n n -

z e i c h n e t , daß mehrere Piezoelement/Metallstreifen-Kombinationen (12) mechanisch und elektrisch parallel geschaltet auf eine Klemmbacke (3) wirken.

4. Klemmvorrichtung nach Anspruch 3, dadurch g e -
k e n n z e i c h n e t , daß die Piezoelement/Metall-streifen-Kombinationen (12) nach Art der Kontaktfedersätze eines elektrischen Relais übereinander angeordnet sind.

FIG.1

FIG.2

0186177

1/2

FIG.3